**Europäisches Patentamt**

**European Patent Office**

**Office européen des brevets**

(19)

(11) Publication number : **0 543 673 A2**

# (12) EUROPEAN PATENT APPLICATION

(21) Application number : **92310646.2**

(22) Date of filing : **20.11.92**

(51) Int. Cl.⁵ : **G06F 15/60**

(30) Priority : **20.11.91 JP 303664/91**

(43) Date of publication of application :
**26.05.93 Bulletin 93/21**

(84) Designated Contracting States :
**DE FR GB**

(71) Applicant : **NEC CORPORATION**
**7-1, Shiba 5-chome Minato-ku**
**Tokyo 108-01 (JP)**

(72) Inventor : **Kojima, Akimichi, c/o NEC**
**CORPORATION**
**7-1, Shiba 5-chome, Minato-ku**
**Tokyo (JP)**

(74) Representative : **Moir, Michael Christopher et**
**al**
**MATHYS & SQUIRE, 10 Fleet Street**
**London EC4Y 1AY (GB)**

(54) **A method for the production of semiconductor memories.**

(57) A method for automatically designing a configuration of a semiconductor memory is provided. The method comprises steps of : determining the placement of memory cells of said memory based on bit information representing a number of bits constituting a word and word information representing a number of words to be stored in said memory ; calculating column-wise and row-wise loads of layout cells to be connected with associated columns and rows of said memory cells in said placement, respectively ; calculating from said calculated loads driving powers required by said layout cells to drive the memory cells associated therewith ; selecting appropriate layout cell sizes that may provide said driving powers required by referring to a look -up table listing a multiplicity of layout cells in terms of the driving power ; and forming peripheral circuits for said memory cells in regions adjacent said memory cells. This method enables quick and efficient designing of a semiconductor memory by eliminating time consuming processes involved in conventional methods.

## FIG.2

START

DETERMINE RAM CONFIGURATION
BASED ON GIVEN BIT INFORMATION
AND WORD INFORMATION.
← STEP 1

CALCULATE LOADS FOR EACH LAYOUT CELL
FOR THE RAM CONFIGURATION ABOVE.
← STEP 2

CALCULATE DRIVING POWERS OF THE CIRCUIT CELLS
FROM THE LAYOUT CELL LOADS ABOVE.
← STEP 3

SELECT APPROPRIATE LAYOUT CELLS HAVING
ABOVE CELL SIZES REFERRING TO
A LOOK-UP TABLE.
← STEP 4

PLACE THE LAYOUT CELLS SELECTED.
← STEP 5

END

EP 0 543 673 A2

Jouve, 18, rue Saint-Denis, 75001 PARIS

## FIELD OF THE INVENTION

The invention relates to the automated designing of and the manufacture of semiconductor memories. The invention particularly relates to a method for the automatic determination and selection of layout cells (unitary layout cells) for driving a matrix of memory cells placed in columns and rows.

## BACKGROUND OF THE INVENTION

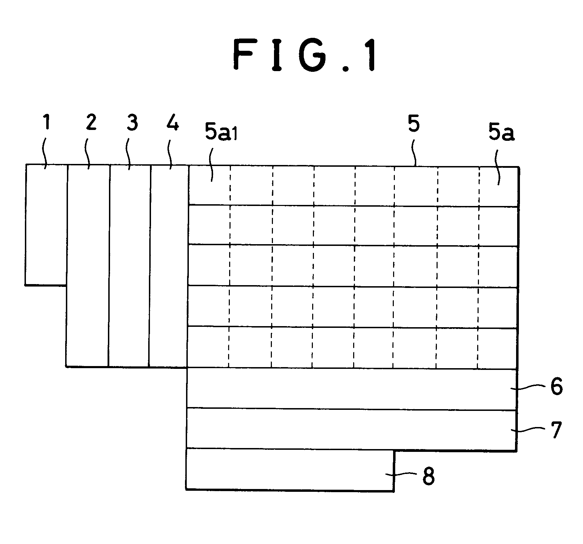

A semiconductor memory such as RAM (Random Access Memory) typically includes, as shown in Fig. 1, a memory cell portion 5 from/into which bit information is read/written, and also includes a peripheral circuit region adjacent to the memory cell portion 5 where peripheral circuits such as a column address buffer 1, a column decoder 2, a row address buffer 8, a sense amplifier 3, a driver 4, a word driver 6, a row decoder 7, a row address buffer 8 are placed for carrying out the read and write operations,

The memory cell portion 5 has a matrix of a plurality of memory cells 5a to allow information bits stored therein or retrieved therefrom in bit -wise read and write operations. The driver 4 and the word driver 6 each have layout cells equal in number to the rows and columns of the cell portion 5, respectively, so that each of their circuit may drive a corresponding row and a corresponding column of the memory cells 5a, respectively. The column address buffer 1 and the row address buffer 8 are provided with sufficient number of layout cells required for transferring addresses. The column decoder 2 and the row decoder 7 have layout cells equal in numbers to the numbers of the columns and rows, respectively, of the memory cells 5a.

When such a RAM as mentioned above is provided with an address from a CPU, say, the address is converted into a corresponding internal address, which is divided into column and row addresses and then stored in an associated address buffer 1 and a row address buffer 8, respectively. These address stored in the buffers are decoded by a respective column decoder 2 and a row decoder 7 to select a corresponding column and a corresponding row of the memory cell portion 5. Then using a driver 4 and a word driver 6, one bit of given information is written in the memory cell 5a specified by these column and row addresses. The sense amplifier 3 and the word driver 6 are used to read one bit of information from a memory cell 5a. The sense amplifier 3 may function to properly maintain the logic level of signals during read and write operations.

Thus, a RAM requires a plurality of peripheral circuits associated with respective columns and rows of the memory cells 5a. Each of such circuits is normally provided with unitary functional blocks of circuitries or layout cells one for each column or one for each row of the memory cells 5a. An important point is that these layout cells must have different driving powers for different memory cells because the load of a layout cell depends on the parameters, e.g. location, of a particular memory cell 5a which the layout cell drives. Consequently, in the design of a layout cell one must determine an appropriate driving power to meet such load requirement. This has been done in the past by estimating necessary driving power of each layout cell and tested in advance in circuit simulations.

Such conventional technique requires tremendous amount of time in getting an adequate configuration of the memory since the simulation must be repeated until appropriate cell sizes are found to meet the load requirements.

## SUMMARY OF THE INVENTION

An object of the invention is, therefore, to provide a method for automatically configuring a semiconductor memory in which appropriate layout cells to be connected with the memory cells are automatically found.

To accomplish the above object, the invention provides a method for automatically designing semiconductor memory, comprising steps of:

determining the placement of memory cells of said memory based on bit information representing a number of bits constituting a word and word information representing a number of words to be stored in said memory;

calculating column-wise and row-wise loads of layout cells to be connected with associated columns and rows of said memory cells in said placement, respectively;

calculating from said loads driving powers required by said layout cells to drive the memory cells associated with said layout cells;

selecting appropriate layout cell sizes that may provide said driving powers required; and

forming peripheral circuits for said memory cells in regions adjacent said memory cells.

The selection of layout cells having appropriate cell sizes may be facilitated by a look-up table which lists a multiplicity of layout cells that can be used for the memory. The look-up table may be programmed in a computer so that the selection may be carried out automatically, thereby enabling quick and efficient designing of semiconductor memories. Thus, conventional time consuming processes such as circuit simulations may be eliminated.

In order to make a semiconductor memory compact, it is preferable to select layout cells having suitable dimensions so as to minimize empty spaces otherwise formed in the memory.

Such semiconductor memory as mentioned above may include at least a column address buffers, a column decoder, a sense amplifier, a write driver, a word driver, a row decoder, and a row address buffer in the peripheral circuit region adjacent the memory cell portion.

The loads of the layout cells may be calculated column-wise and row-wise, in association with respective columns and rows of the memory cells, by multiplying column-wise/row-wise loads per word by the number of words contained in the associated columns and rows, respectively.

The layout cell sizes may be also calculated independently column-wise and row-wise, by multiplying the column-wise/row-wise loads for one word by the number of words in the associate columns and rows, respectively.

These calculations allows quick and accurate determination of the cell sizes needed.

In another aspect of the invention, there is provided a method for automatically designing semiconductor memory by selecting layout cells to be connected with associated columns and rows of memory cells of said memory so that said layout cells have appropriate drive powers to drive said associated memory cells. The method comprises steps of:

determining the placement of said memory cells in the form of two memory arrays, based on bit information representing a number of bits constituting a word and word information representing a number of words to be stored in said memory;

calculating column-wise and row-wise loads of layout cells to be connected with associated respective columns and rows of said memory cells in said memory arrays.

calculating the sizes of said layout cells, said sizes representing the driving powers necessary for respective layout cells to drive said memory cells associated therewith in said placement;

selecting appropriate layout cells having required driving powers by referring to a look-up table listing layout cells in terms of layout cell size; and

arranging said memory arrays symmetrically at the opposite sides of the layout cells which are connected with both memory arrays.

This approach wil reduce the amount of work required for designing semiconductor memories by a factor of about 2. Furthermore, this method permits elimination of empty spaces in the memory, thereby providing a compact and efficient memory.

The invention also includes producing semiconductor memories by automatically designing them as aforesaid and then manufacturing them to the design.

Thus, the invention provides in another aspect a method of manufacturing a semiconductor memory, comprising: automatically determining the positions of memory cells of said memory on the basis of bit information representing a number of bits constituting a word and word information representing a number of words to be stored in said memory; automatically calculating column-wise and row-wise loads of layout cells to be connected with associated columns and rows of :aid memory cells in said placement, respectively; automatically calculating from said calculated loads driving powers required by said layout cells to drive the memory cells associated therewith; automatically selecting appropriate layout cell sizes to provide said driving powers required; manufacturing memory cells in said determined positions; and manufacturing peripheral circuits for said memory cells comprising said appropriately-sized layout cells in regions adjacent said memory cells.

In a further aspect the invention provides a method of manufacturing a semiconductor memory in which layout cells are connected to to associated columns and rows of memory cells of said memory, the method comprising: automatically determining the position of said memory cells in the form of two memory arrays, based on bit information representing a number of bits constituting a word and word information representing a number of words to be stored in said memory; automatically calculating column-wise and row-wise loads of layout cells to be connected with respective associated columns and rows of said memory cells in said memory arrays; automatically calculating the sizes of said layout cells, said sizes representing the driving powers necessary for respective layout cells to drive said memory cells associated therewith in said memory arrays, automatically selecting appropriate layout cells having required driving power by referring to a look-up table listing layout cells in terms of layout cell size; manufacturing memory cells in said determined positions in said two memory arrays; manufacturing said layout cells; and arranging said memory arrays symmetrically at the opposite sides of the layout cells; and connecting the layout cells to both memory arrays.

## BRIEF DESCRIPTION OF THE DRAWINGS

Figure 1 is a diagram illustrating a general concept of designing a RAM configuration.

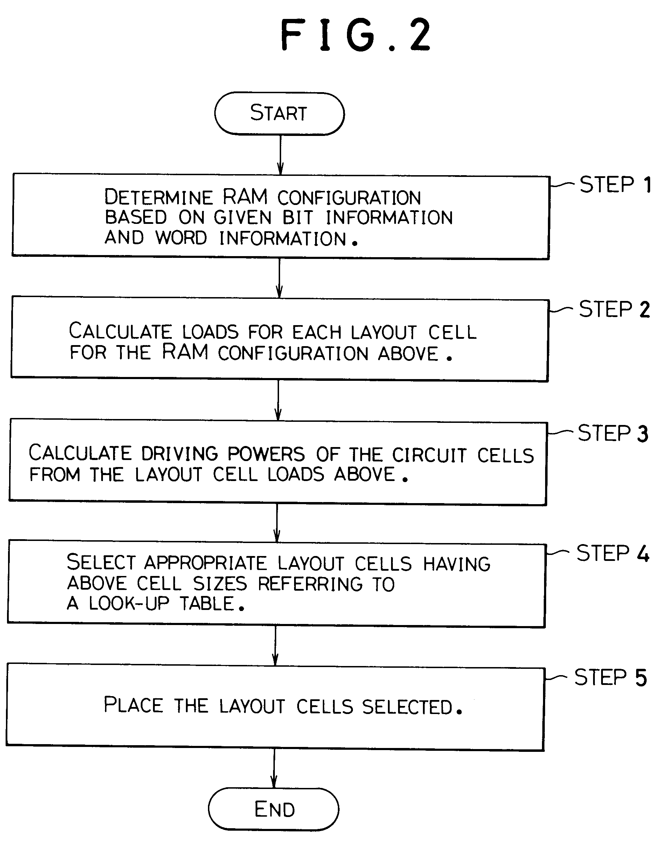

Figure 2 shows procedures for automated designing of a RAM according to the invention.

Figure 3 is a look-up table listing column-wise layout cells in terms of the cell size.

Figure 4 is a look-up table listing the row-wise layout cells in terms of the cell size.

Figures 5 and 6 are physical diagrams showing how an empty space may be eliminated from a layout cell region of a memory.

Figure 7 is a physical diagram for use in illustrating how empty spaces may be minimized efficiently in designing a RAM.

## DESCRIPTION OF THE PREFERRED EMBODIMENT

The invention is now described by way of example with reference to the accompanying drawings, specifically for a case of automated designing of a RAM configuration.

An automated designing of a RAM configuration of the invention may be carried out through the following steps:

### STEP 1

The numbers of memory cells 5a to be placed in one column and one row, respectively, are determined based on given bit information representing the number of bits for one word and word information representing the number of words to be stored in a matrix of columns and rows of the memory.

The numbers of the columns and the rows are preferably determined so that the resultant matrix becomes as square as possible. Further, column-wise memory cells are normally placed in unit of word, so that no fractional word will result in. For example, in a case where a 16-word RAM is to be configured with one word consisting of 4 bits, two words or 8 bits are assigned to each column, so that 16 words are distributed over 4 rows. However, when the number of words to be stored in a RAM is smaller than the number of bits in one word, each word may be folded into two rows in such a way that the total number of bits in a row is a power of 2 and that the matrix of the memory cells becomes as square as possible. For example the memory cells of a RAM for two 8 bit-words may be placed in a matrix of columns and rows each containing 4 bits.

### STEP 2

After determining the placement of the memory cells, loads of layout cells of the column address buffer 1, column decoder 2, sense amplifier 3, write driver 4, word driver 6, row decoder 7, and row address buffer 8, are calculated column-wise and row-wise using the following equations (1) and (2).

$$\text{Column - wise load} = (\text{column - wise load per word}) \times (\text{number of words per column}). \quad (1)$$
$$\text{Row - wise load} = (\text{row - wise load per word}) \times (\text{number of words per row}). \quad (2)$$

where the column address buffer 1 and the row address buffer 8 each have a number of layout cells necessary for transferring address bits; the column decoder 2 and the row decoder 7 each have layout cells equal in number to the columns and the rows, respectively, of the memory cells 5a.

The quantity "column-wise load per word" is defined, for example for a RAM for 8-bit words, as the load for an 8-bit word. It should be noted that such load depends on the characteristics of a particular memory cell 5a and its location in the matrix, and that the load may be evaluated in advance in preliminary measurements. Similarly, "row -wise load per word" is the load for 8-bit memory cells connected in a row in the case of 8-bit word memory, which may be determined also in preliminary measurements.

The "number of column-wise words" is defined as the number of words placed in a column. Hence, the number of words will be 0. 5 when one word is split into two equal sections. As an example, the number of column-wise words for a sense amplifier connected with 8-bit word memory cells 5a in the first column and the first row, shown in Fig. 1, equals 1/8.

The number of row-wise words is defined as the number of words contained in a row. For example in a case of 8-bit word RAM, the number of row-wise words for a word driver connected with the first column of the first row of the memory cell 5al shown in Fig. 1, is 5/8.

In this manner Equations (1) and (2) yield column-wise and row-wise loads for the column and the row, respectively, representing the magnitudes of the loads in the respective column and row, respectively.

### STEP 3

Following the determination of the loads in STEP 2, necessary cell sizes are determined using the following equations (3) and (4).

$$\text{Column - wise cell size} = \text{load} \times (\text{Column - wise cell size per unit load}) \quad (3)$$
$$\text{Row - wise cell size} = \text{load} \times (\text{row - wise cell size per unit load}) \quad (4)$$

In these equations, the quantities "Column-wise cell size per unit load" and "Column -wise cell size per unit load" are normalized values of powers, i.e. powers required for the layout cells belonging to a column and a row, respectively, to drive memory cells for 1 word, in the column and row, respectively, and are determined in actual measurements. These values represent the sizes of a column and a row, respectively (which will be referred to as basic sizes). Thus, the column-wise layout cell size and the row-wise layout cell may be determined by multiplying these basic sizes by the loads obtained in STEP 2. The resultant column-wise layout cell size represents the total size of layout cells required to drive a particular set of column -wise memory cells selected in the column. Similarly, the row -wise layout cell size represents the total size of layout cells required to drive a particular set of row -wise memory cells selected in the row. By selecting all possible combinations of memory cells in a given column or row, a range of column-wise or row-wise cell sizes may be obtained for the column or the row.

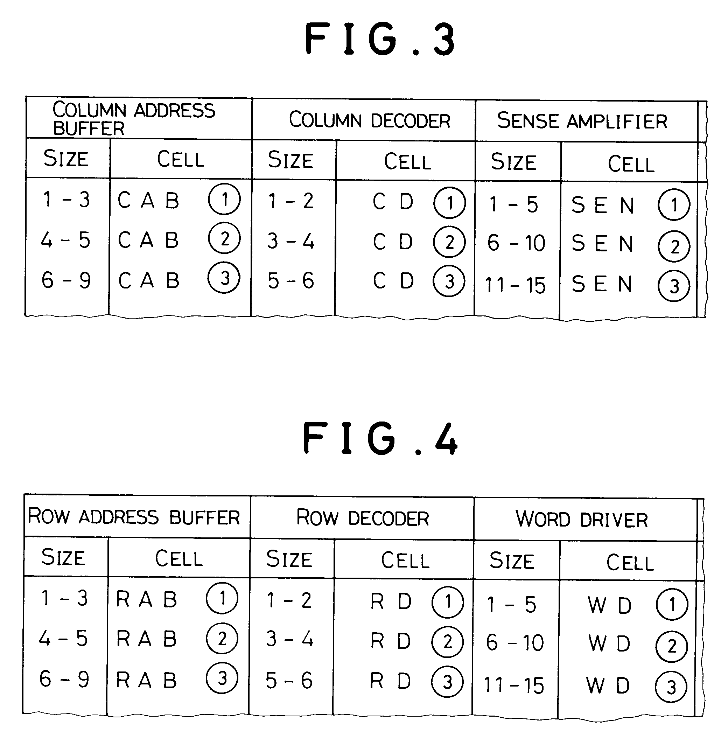

It should be understood that in order to calculate the column-wise and row-wise loads and column-wise and row-wise layout cell sizes in the automated design of a RAM, actual values of the column-wise and row-wise load per word as well as column-wise and row-wise layout cell size per word are measured prior to the designing and tabulated in a look-up table, as shown in Figs. 3 and 4. It should be noted that such look -up table, if constructed once, may be utilized for different RAM configurations.

STEP 4

In this step, suitable layout cells are selected to meet the requirement for the cell sizes calculated in STEP 3. The selection may be carried out automatically by referring to the look-up table.

STEP 5

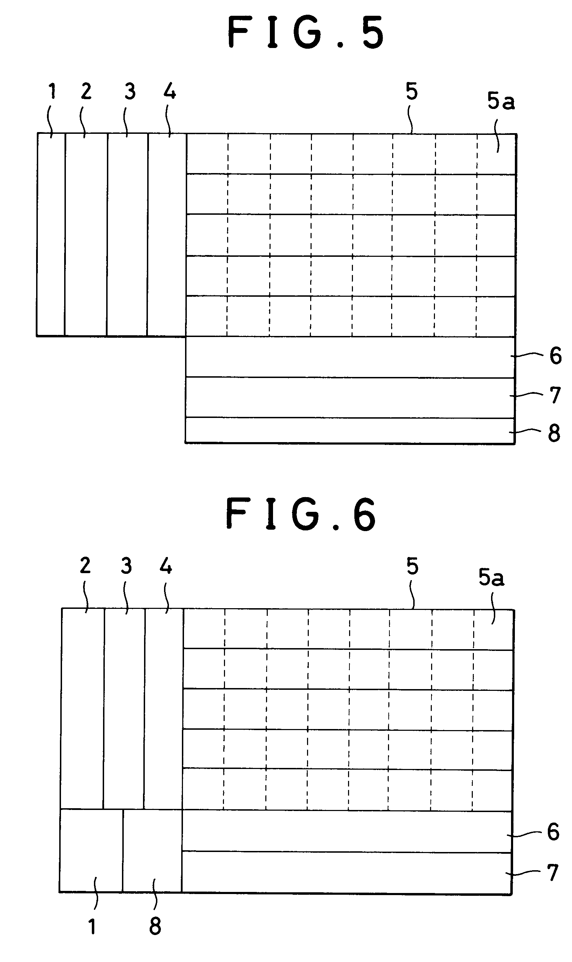

In this step a favorable placement is determined for the layout cells selected in STEP 4. It should be noted that the column address buffer 1 and the row address buffer 8 have less numbers of layout cells compared with other circuits, so that empty spaces can be created in the peripheral circuit region if they are formed in arbitrary dimensions and placed at arbitrary locations as shown in Fig. 1. In order to make the entire memory compact by eliminating such empty space, they are preferably formed in rectangles having optimum lengths and widths so as to fit in a given peripheral circuit region. For this optimization, various types of rectangles having different lengths and widths are also made available in the look-up table for a given layout cell size. After such optimization the placement of the layout cells contain no or only negligible empty space as shown in Figs. 5 and 6.

Thus, in the method described above, designing a RAM configuration for a given memory size is greatly simplified, since it may be carried out in an automated manner through: determination of the loads of the layout cells in accordance with Equations (1) and (2); determination of layout cell sizes for the loads in accordance with Equations (3) and (4); selection of appropriate layout cells to meet the layout cell requirements with reference to the look-up table prescribing the layout cell sizes of the relevant layout cells. As pointed out above the method may eliminate time consuming procedures such as circuit simulations in designing a compact RAM.

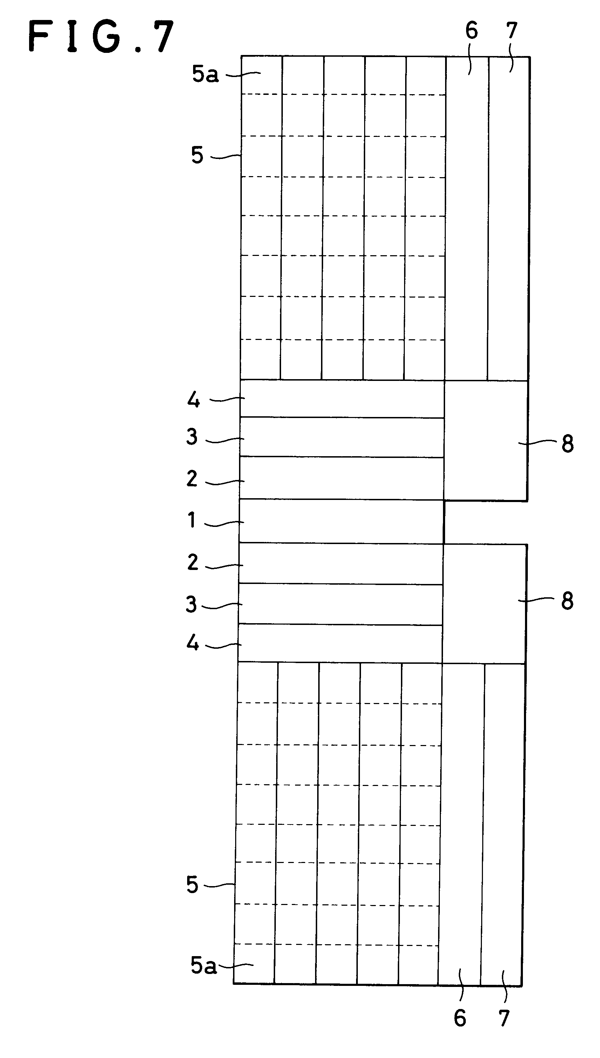

Fig. 7 illustrates another method embodying the invention, which is useful in designing a large scale RAM. In this method, the RAM is divided into two halves, with a first one having a form similar to the one shown in Fig. 5 and a second one having a form obtained by inverting the first one.. The halves are then placed symmetrically at the opposite sides of the column address buffer 1 in such a way that each empty space at the corner of the memory as seen in Fig. 5 is filled with the row address buffer 8. In this example a column address buffer 1 is used by both memory arrays.

This approach permits the use of small RAM designing technique for a large scale RAM designing and hence reduces designing work by a factor of 2. Furthermore, this approach permits of efficient utilization of a layout cell region, leaving negligible empty spaces in the memory.

## Claims

1. A method for automatically designing a configuration of a semiconductor memory, comprising steps of:

    determining the placement of memory cells of said memory based on bit information representing a number of bits constituting a word and word information representing a number of words to be stored in said memory;

    calculating column-wise and row-wise loads of layout cells to be connected with associated columns and rows of said memory cells in said placement, respectively;

    calculating from said calculated loads driving powers required by said layout cells to drive the memory cells associated therewith;

    selecting appropriate layout cell sizes to provide said driving powers required; and

    forming peripheral circuits for said memory cells in regions adjacent said memory cells.

2. A method as claimed by claim 1, wherein said step of selecting appropriate layout cells having said driving power is carried out by referring to a look-up table listing a multiplicity of layout cells in terms of the driving power.

3. A method as claimed by claim 2, wherein said look-up table further contains a multiplicity of alternative layout cell configurations for each of layout cell sizes so that a best layout cell configuration may be selected to leave least empty space in said peripheral circuit regions.

4. A method as claimed by any preceding claim, wherein said semiconductor memory is provided with at least one column address buffer, one column decoder, one sense amplifier, write driver, one word driver, one row decoder, and one row address buffer.

5. A method as claimed by any preceding claim, wherein said of said column-wise/row-wise loads are calculated independently, and each of said loads is obtained from the column-wise row-wise load per one word multiplied by the number of words in the column/row.

6. A method for automatically designing a configuration of a semiconductor memory by selecting layout cells to be connected with associated columns and rows of memory cells of said memory so that said layout cells have appropriate drive powers to drive said associated memory cells, comprising steps of:

determining the placement of said memory cells in the form of two memory arrays, based on bit information representing a number of bits constituting a word and word information representing a number of words to be stored in said memory;

calculating column-wise and row-wise loads of layout cells to be connected with respective associated columns and rows of said memory cells in said memory arrays;

calculating the sizes of said layout cells, said sizes representing the driving powers necessary for respective layout cells to drive said memory cells associated therewith in said memory arrays,

selecting appropriate layout cells having required driving power by referring to a look-up table listing layout cells in terms of layout cell size; and

arranging said memory arrays symmetrically at the opposite sides of layout cells which are connected with both memory arrays.

7. A method of manufacturing a semiconductor memory, comprising:

automatically determining the positions of memory cells of said memory on the basis of bit information representing a number of bits constituting a word and word information representing a number of words to be stored in said memory;

automatically calculating column-wise and row-wise loads of layout cells to be connected with associated columns and rows of said memory cells in said placement, respectively;

automatically calculating from said calculated loads driving powers required by said layout cells to drive the memory cells associated therewith;

automatically selecting appropriate layout cell sizes to provide said driving powers required;

manufacturing memory cells in said determined positions; and

manufacturing peripheral circuits for said memory cells comprising said appropriately-sized layout cells in regions adjacent said memory cells.

8. A method of manufacturing a semiconductor memory in which layout cells are connected to to associated columns and rows of memory cells of said memory, the method comprising:

automatically determining the positions of said memory cells in the form of two memory arrays, based on bit information representing a number of bits constituting a word and word information representing a number of words to be stored in said memory;

automatically calculating column-wise and row-wise loads of layout cells to be connected with respective associated columns and rows of said memory cells in said memory arrays;

automatically calculating the sizes of said layout cells, said sizes representing the driving powers necessary for respective layout cells to drive said memory cells associated therewith in said memory arrays,

automatically selecting appropriate layout cells having required driving power by referring to a look-up table listing layout cells in terms of layout cell size;

manufacturing memory cells in said determined positions in said two memory arrays;

manufacturing said layout cells; and

arranging said memory arrays symmetrically at the opposite sides of the layout cells; and connecting the layout cells to both memory arrays.

# FIG.1

# FIG.2

```
                    ┌─────────────┐
                    │    START    │
                    └─────────────┘
                           │
                           ▼
    ┌──────────────────────────────────────────┐  ─ STEP 1
    │  DETERMINE RAM CONFIGURATION              │
    │  BASED ON GIVEN BIT INFORMATION           │
    │  AND WORD INFORMATION.                     │
    └──────────────────────────────────────────┘
                           │
                           ▼
    ┌──────────────────────────────────────────┐  ─ STEP 2
    │  CALCULATE LOADS FOR EACH LAYOUT CELL      │
    │  FOR THE RAM CONFIGURATION ABOVE.          │
    │                                            │
    └──────────────────────────────────────────┘
                           │
                           ▼
    ┌──────────────────────────────────────────┐  ─ STEP 3
    │  CALCULATE DRIVING POWERS OF THE CIRCUIT CELLS │
    │  FROM THE LAYOUT CELL LOADS ABOVE.         │
    │                                            │
    └──────────────────────────────────────────┘
                           │
                           ▼
    ┌──────────────────────────────────────────┐  ─ STEP 4
    │  SELECT APPROPRIATE LAYOUT CELLS HAVING    │
    │  ABOVE CELL SIZES REFERRING TO             │
    │  A LOOK-UP TABLE.                          │
    └──────────────────────────────────────────┘
                           │
                           ▼
    ┌──────────────────────────────────────────┐  ─ STEP 5
    │                                            │
    │  PLACE THE LAYOUT CELLS SELECTED.          │
    │                                            │
    └──────────────────────────────────────────┘
                           │
                           ▼
                    ┌─────────────┐
                    │     END     │
                    └─────────────┘
```

# F I G . 3

| COLUMN ADDRESS BUFFER | | COLUMN DECODER | | SENSE AMPLIFIER | |
|---|---|---|---|---|---|
| SIZE | CELL | SIZE | CELL | SIZE | CELL |
| 1 – 3 | C A B ①  | 1 – 2 | C D ①  | 1 – 5 | S E N ①  |
| 4 – 5 | C A B ②  | 3 – 4 | C D ②  | 6 – 10 | S E N ②  |
| 6 – 9 | C A B ③  | 5 – 6 | C D ③  | 11 – 15 | S E N ③  |

# F I G . 4

| ROW ADDRESS BUFFER | | ROW DECODER | | WORD DRIVER | |
|---|---|---|---|---|---|
| SIZE | CELL | SIZE | CELL | SIZE | CELL |
| 1 – 3 | R A B ①  | 1 – 2 | R D ①  | 1 – 5 | W D ①  |
| 4 – 5 | R A B ②  | 3 – 4 | R D ②  | 6 – 10 | W D ②  |
| 6 – 9 | R A B ③  | 5 – 6 | R D ③  | 11 – 15 | W D ③  |

# FIG.5

# FIG.6

# FIG.7